(19)

Europäisches
Patentamt

European
Patent Office

Office européen
des brevets

(11) **EP 2 782 251 A1**

(12) **EUROPEAN PATENT APPLICATION**

(43) Date of publication:
24.09.2014 Bulletin 2014/39

(51) Int Cl.:
*H03K 5/24* (2006.01)

(21) Application number: 13160527.1

(22) Date of filing: 22.03.2013

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**

(71) Applicant: **Technische Universität Darmstadt
64285 Darmstadt (DE)**

(72) Inventors:
• **Glesner, Manfred Prof. Dr.
64354 Reinheim (DE)**
• **Ganesan, Ramkumar
64293 Darmstadt (DE)**

(74) Representative: **Stumpf, Peter
c/o TransMIT GmbH
Kerkrader Strasse 3
35394 Gießen (DE)**

(54) **Inverter based comparator**

(57)     The invention relates to an inverter based comparator with variable switching point inverters and a completely digital Flash ADC design using variable switching point inverter based comparator to propose a favorable system, which is robust against parameter variation and mismatch.

## Fig 3.

CMOS Inverter-based comparator circuit (Vdd is positive here)

EP 2 782 251 A1

## Description

The invention relates to an inverter based comparator with variable switching point inverters and a completely digital Flash ADC (analog digital converter) design using variable switching point inverter based comparator.

Electronic devices comprising organic semiconductors are primarily P-type devices. Though N-type organic devices are able to be produced, their performance is far inferior compared to P-type organic thin film transistors (OTFTs) and stability is also an issue with N-type organic devices. The invention is also related to silicon based PMOS or NMOS circuits too.

The OTFTs and MOS transistors have huge parameter variation and mismatch effects. This offers a big challenge to build analog circuits like comparators and ADC. On the other hand, the digital circuits are less affected by the parameter variation and mismatch effects. Therefore, a better solution is to design digital inverter-based comparator circuit and digital ADC that are not very much affected by variations.

ADC is a fundamental block of any sensor systems or any system that is interfaced to real world analog signal input. All the real world signals around us are in analog domain. But for processing the information conveyed by these analog signals, the digital circuits are required as they are cheaper and faster. So any such system requires an ADC system to convert the analog signal to digital domain. Comparator is by itself a 1 bit ADC. But in majority of the application scenarios, it is required to have an ADC with more than 1 bit resolution. This necessitates the use of complex ADC architectures. Almost all of these ADCs use one or more comparators. The fastest of all the ADC architecture is the Flash type ADC. The major disadvantage with a Flash type ADC is that it requires $2^n - 1$ comparators, where n is the number of output bits (i.e. resolution). This increases the area and cost of the IC tremendously. Since the inverter-based comparator consumes less area than an analog comparator, this issue can be solved to some extent by employing digital inverter-based comparators. Such a Flash ADC using digital comparators are can be considered as digital Flash ADC structures.

In general a Flash type ADC consists of a comparator array and an encoder circuit. The comparator switches its output when the input crosses the reference voltage. When the reference voltage is chosen at linear voltage intervals, the digital output from the comparator array is a unitary code(thermometer code). The encoder converts the thermometer code into a binary code.

Conventionally, an inverter based comparator array, for use in a digital Flash ADC, consist of inverters with linearly varying threshold voltage. The output switching voltage of the inverter is the implicit reference voltage of the inverter based comparator. When the Vin crosses the respective switching voltage of the inverter (Vref here), the output of the inverter switches thus behaving like a comparator. The output switching point of an inverter depends on the width and length of the load and driver transistor of the inverter. To implement a comparator array for use in a digital Flash ADC, we need inverters with varying switching voltages. One common way to vary the switching voltage of an inverter is by geometrically scaling the width (W) and/or length (L) of the transistors. The disadvantage with this is that, the scaling of transistor dimension is not perfect due to the parameter variation and mismatch effects, and this eventually exhibits as non-idealities in the ADC conversion mechanism. Other methods involve using driver transistors with different threshold voltages (Vt) corresponding to the required Vref of the inverter-based comparator. Again controlling threshold voltage is prone to imperfections arising from the process variations. Moreover, controlling of Vt is not possible with organic circuit technology. Therefore it is required to design an inverter-based comparator whose response to a given reference voltage can be controlled without using any geometric scaling or threshold voltage manipulation.

## State of the Art/Prior Art

The existing prior art inverter based comparator circuits use transistor sizing or stacked transistors using delayed output-feedback, using capacitive coupling, tapped delay line or by changing well bias.

From the state of the art the following documents are cited as examples of the above mentioned inverter based comparator circuits:

> 1. US patent, US 2008/0054943 A1 , Ravindraraj Ramaraju et al., 09/2006
> 2. US patent, 7315272 B2, Day-Uei Li et al., 01/2008
> 3. US patent, 6661365 B1, Alexander Bugeja , 12/2003
> 4. Komar, Rajeev; Bhat, M S; Laxminidhi, Tonse; "A 0.5V 300μW 50MS/s 180nm 6bit Flash ADC using inverter based comparators," Advances in Engineering, Science and Management (ICAESM), 2012 International Conference on , pp.331-335, 2012
> 5. Denis C. Daly, Anantha P. Chandrakasan , "A 6-bit, 0.2 V to 0.9 V Highly Digital Flash ADC with Comparator Redundancy", IEEE JOURNAL OF SOLID-STATE CIRCUITS, Vol. 44, No. 11, 2009

A comparator is a device that compares two signals and switches its output to indicate which is larger. They are common devices to built up analog-to-digital converters (ADCs).

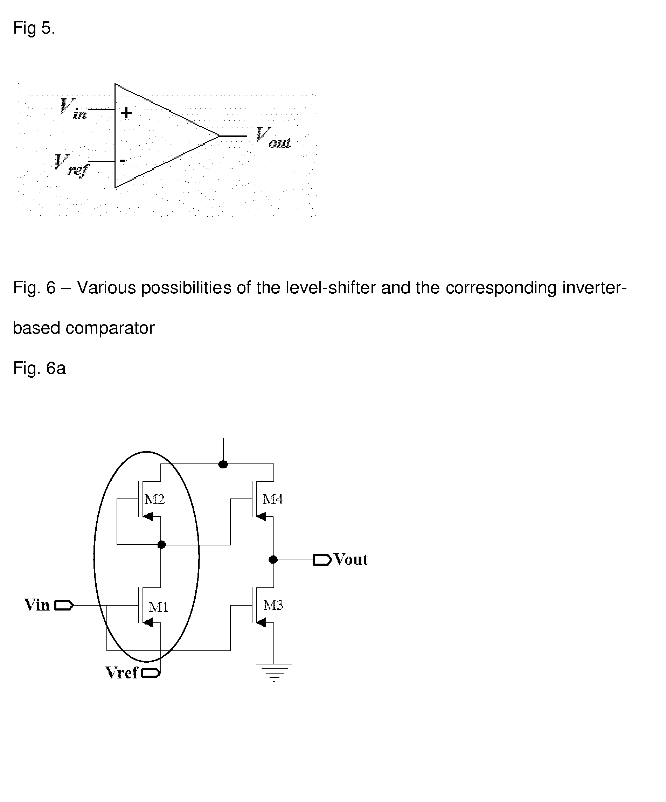

Inverters are basic building blocks for any microelectronic circuits. It is used as a switch for digital applications and as an amplifier in analog applications. A PMOS organic inverter consists of minimum two organic transistors i.e. a load and a driver transistor. The input is connected to the gate of the driver transistor and output is taken from the drain of driver transistor. Inverts are commonly used to built up comparators (inverter based comparators). Conventionally, the comparators consist of an operational-amplifier (shown in Fig.5).

The invention proposed in [1] relates to a flash ADC using inverter based comparators. Here a delayed output feedback method is used. This suffers from non-linearity effects.

In [2] a floating resistor ladder and a constant current source to form the Flash ADC is proposed. Here the ADC suffers from the non-linearity associated with the current source.

In [3] a tapped delay line is proposed to realize inverter based comparator. The proposed device also uses a well bias to change the threshold voltage of the transistor. It requires complicated technology process involving biasing of the well. It is not suitable for organic electronics that has no well.

In [4] a clock phasing and capacitive coupling to realize inverter based comparator proposed. The drawback in this proposed device is that it requires 7 switches. The Clock jitter and the switch noise will affect the performance.

The invention proposed in [5] proposes stacked transistors to realize variable switching voltage inverter based comparator. The voltage transfer curve here exhibits high non-linearity.

**Task of the invention**

Therefore it is the task of the invention to reduce the disadvantages in the prior art and to propose a favorable system, which is robust against parameter variation and mismatch.

The invention relates to electronic devices especially comparators comprising organic semiconductors that are primarily P-type devices. This is also applicable to all PMOS electronic circuits using other semiconductor materials like Si, amorphous silicon etc. Though N-type devices are producible, their performance is today far inferior compared to P-type organic thin film transistors (OTFTs). Their stability is also inferior compared to P-type devices. P-and N- type OTFTs use different organic materials. Complementary OTFT circuits usually need to incorporate slower and less reliable N-type OTFT and also involve additional processing steps.

Considering the above reasons, organic CMOS devices are no viable option at the moment. So, the organic circuit design for the usage of the invention within an inverter circuit was continued with only PMOS devices.

This is analogous to amorphous-Si devices in the sense that they are only N-type and CMOS devices using amorphous-Si are not feasible. The OTFTs are mostly depletion type devices (normally on). Doping of organic semiconductors poses a bigger challenge and so it is difficult to produce enhancement type (normally off) devices. Nevertheless it could be done, but the reliability of such a device is a matter of concern too.

**Detailed description of the invention**

A comparator is a device that compares two voltages or currents and switches its output to indicate which is larger. It has two input terminals i.e. inverting and non-inverting. A standard voltage known as reference voltage Vref is connected to either inverting or non-inverting terminal. The voltage to be compared is connected to the other terminal. The output (Vout) of the comparator can switch between positive and negative saturation voltage (Vsat) such that
If Vin > Vref, Vout = +Vsat
Vin < Vref, Vout = -VsatThe Comparator comprises an input stage coupled to a input voltage Vin and a reference voltage Vref and build up by a transistor M1 and preferably a transistor M2 and an output stage build up by a transistor M3 and a transistor M4 with two output levels +Vsat and -Vsat, Vout as output whereby the input Voltage Vin, which is either an analog or a digital signal, is connected to the gate of the transistor M1 and the reference voltage Vref, which is either an analog or a digital signal, is connected to the source of the transistor M1 (or vice versa where Vin is connected to source terminal of M1 and Vref is connected to gate terminal of M1) and whereby the remaining contact i.e. drain of M1 is connected to the gate of M4 and the generated difference output signal of M1 at gate of M4 triggers M4 to supply +Vsat as Vout and whereby the input Voltage Vin is also connected to the gate of M3 and the input Voltage Vin at gate of M3 triggers M3 to supply -Vsat as Vout. Vout can be analog or digital.

A Method for running the proposed comparator comprises the following steps:

1. input Voltage Vin trigger M3 to supply -Vsat as Vout and

2. difference signal of Vref and Vin is generated in M1 and afterwards difference signal of Vref and Vin trigger M4 to supply +Vsat as Vout

For an operational-amplifier based comparator, the saturation voltage Vsat is equal to the supply voltage. The disadvantage with the analog comparator is that it requires large area and so the cost is increased. In addition, for a better performing analog comparator, the transistor matching is critical. The parameters and eventually the transistor current vary in due to the process variations, changes in temperature, presence of impurities etc. Now organic thin-film transistors suffer from large parameter variations and mismatch effects that make the task of designing an analog (Op-amp -based) comparator a much difficult task. This leads to inverter-based comparator as a alternative as far as organic circuits are concerned. Since the inverters are a digital component, and the structure doesn't require stringent transistor matching criterion, the performance of such a digital comparator is good in presence of large parameter variations and mismatch effects.

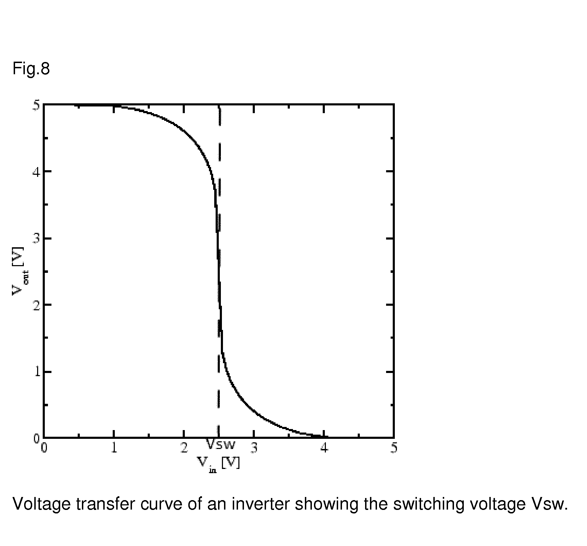

The inverter is an electronic device consisting of a driver transistor and an active or passive load structure. The voltage transfer curve of an inverter is shown in Fig.8. The output of the inverter switches when the input crosses the inverter switching voltage (Vsw). Thus in this proposed solution the propsed inverter behaves as a comparator where the reference voltage is the inverter switching voltage. To realize a Flash ADC a set of comparators is used. Each have different reference voltages that vary at regular intervals. This requires an array of inverter-based comparators , whose switching voltage (i.e. reference voltage) are separated by regular intervals. If the switching voltage (i.e. reference voltage) of the inverters used in a Flash ADC doesn't vary in linear intervals, the resolution of the ADC is affected. Thus it is of high importance to design an array of inverter-based-comparator that has switching voltages at regular intervals.

The equation for the inverter switching voltage Vsw is given below, where Vsup is the power supply, $V_{Tp}$, $V_{Tn}$ are the threshold voltages of load and driver transistor respectively, Kp and $K_n$ are the current prefactors of load and driver transistors respectively. $K_{p,n}$ is a function of W/L, mobility ($\mu$), gate oxide capacitance ($C_{ox}$).

$$V_{sw} = \frac{r(V_{sup} - |V_{Tp}|) + V_{Tn}}{1 + r}$$

$$r = \sqrt{\frac{K_p}{K_n}}$$

So Vsw is a function of power supply Vsup, threshold voltages of driver and load transistor and ratio of current prefactor of load and driver transistor. Here a CMOS inverter is considered where the driver is NMOS and load is a PMOS device. Therefore the switching voltage is varied by

1. Varying the power supply voltage Vsup or

2. Varying the transistor (W/L) ratios i.e. $(W/L)_{Load}$ / $(W/L)_{Driver}$ of load and driver transistor or

3. Varying the threshold voltages of the load and driver transistors

Transistor width and length are easily affected by process variations. Thus varying the W/L ratio of load and driver transistors lead to non-idealities that reduce the resolution of the Flash ADC. Varying the threshold voltage of transistor requires a precise control over the doping process and this is also much affected by process variations. Moreover, it is very difficult to control the threshold voltage in organic thin-film transistors. Due to the above statements, the best possible solution to vary the inverter switching voltage is by varying the power supply voltage.

In the proposed an adapted version of the simple inverter-based comparator is used. We additionally use a level-shifter stage where the reference voltage is connected to the source of the driver transistor of the level-shifter stage. Thus the rail-to-rail supply voltage of the level-shifter is between the VDD and reference voltage. Vsup = VDD - Vref. Thus as Vref is varied linearly, the supply voltage of the level-shifter and in turn the inverter switching voltage is varied linearly. Changes in the rail-to-rail supply voltage of the level-shifter leads to a corresponding change in its output voltage swing. But for the output of the comparator to be recognized by the following digital gates, the output voltage swing needs to be maintained at a certain level that is within the noise margins of the following digital gates. So we employ an output/inverter stage that has a fixed power supply voltage (Vsup = VDD - 0). Thus no matter what the reference voltage is, the output of the whole inverter-based comparator has the pre-defined output voltage swing.

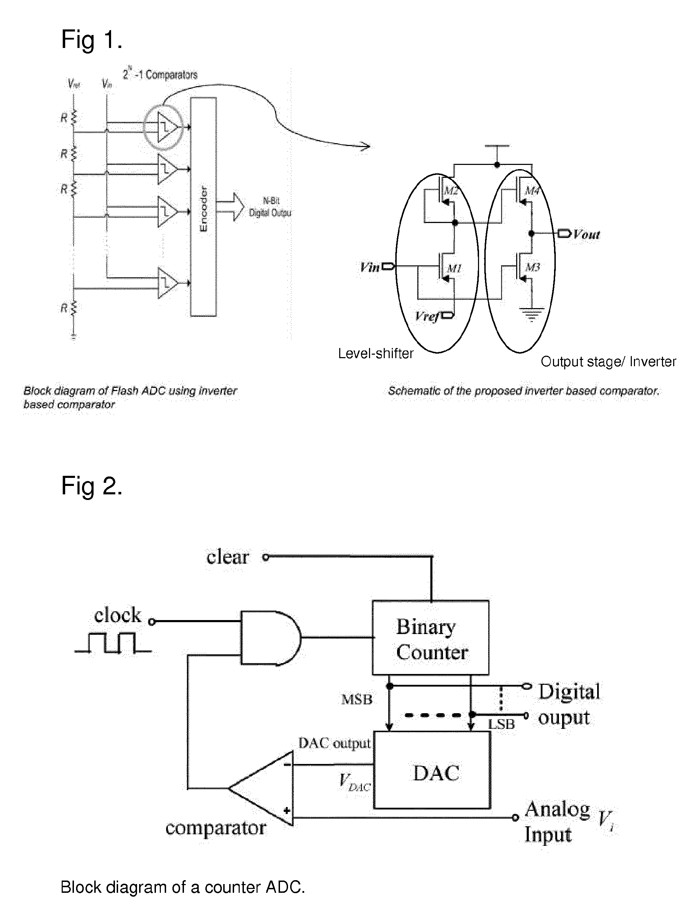

The proposed inverter based comparator is shown in Fig.1. The transistors M1 and M2 form the input level-shifter stage. In an exemplary embodiment M2 is formed as a cut-off load but this can be replaced by any load structure (active or passive). The transistors M3 & M4 form a pull-up/pull-down output stage or an inverter. Vin is connected to gate terminal of M1. The reference voltage Vref is connected to the source terminal of M1.

Thus

$$\text{Vgs eff,M1} = \text{Vgs, M1} - \text{Vt.}$$

$$\text{Vgs eff,M1} = (\text{Vin} - \text{Vref}) - \text{Vt}$$

Here Vgs,eff is the effective gate over drive voltage. This combines the externally applied gate-source voltage and the internal threshold voltage value of the transistor. Vin is the input to the comparator and Vref is the reference voltage. Vt is the threshold voltage of M1. Thus the transistor M1 also acts as a voltage subtractor wherein, it subtracts Vin and Vref.

To realize a comparator array that is required for Flash ADC architecture, the Vref is chosen at linear intervals. Here neither the threshold voltage Vt is manipulated nor the geometric scaling of the transistor dimensions employed. So the circuit represents a standalone digital comparator (inverter based comparator) that is not affected by the parameter and process variations, and mismatch effects. All the transistors used in the circuit are of same type. They are either n-type or p-type transistors. This allows the construction of monotype comparators, which is advantageous especially but not only for organic semiconductor circuits.

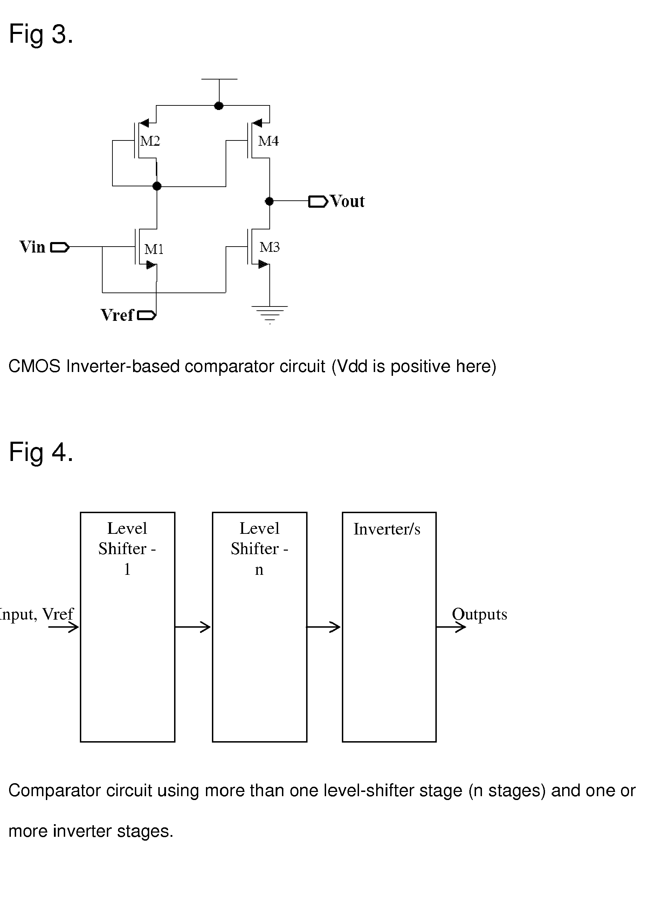

In a further embodiment, the inverter-based comparator circuit contains cascaded level-shifters having more than one level-shifting stage and one or more inverter stages. This is shown in Fig.4.

As a result the inverter-based comparator's switching voltage varies linearly with Vref. This linearity leads to achieve very high resolution especially if it is used in ADCs.

In a further embodiment a flash ADC comprises at least one proposed inverter-based comparator.

In a further embodiment a counter ADC comprises the proposed inverter-based comparator. A counter ADC architecture is one of the simplest ADC architectures. It contains a comparator, DAC and control logic. The analog input voltage is compared with the output from the DAC by using a comparator. The output from the DAC is connected to the reference voltage input of the comparator. The control logic systematically increases the reference voltage until the reference voltage becomes larger than the analog input voltage. When the reference voltage is greater than the analog input, the comparator output goes zero and the corresponding digital code is output.

In a further embodiment M2 is formed as a diode-load device. In an exemplary embodiment here the Gate of M2 is connected to the drain of M2.

In a further embodiment M2 is formed as a passive device.

In a further embodiment employing complementary type transistors form a CMOS-type inverter based comparator. The schematic of such a CMOS comparator is shown in Fig.3. Transistors M1 and M3 are n-type, and transistors M2 and M4 are p-type.

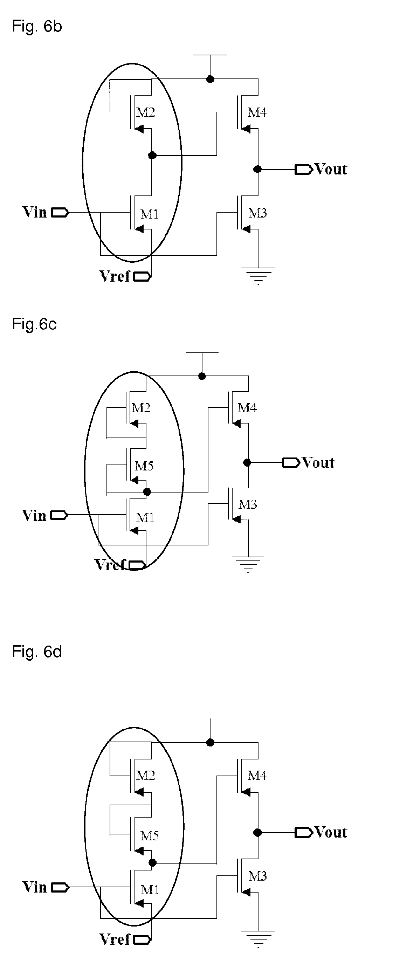

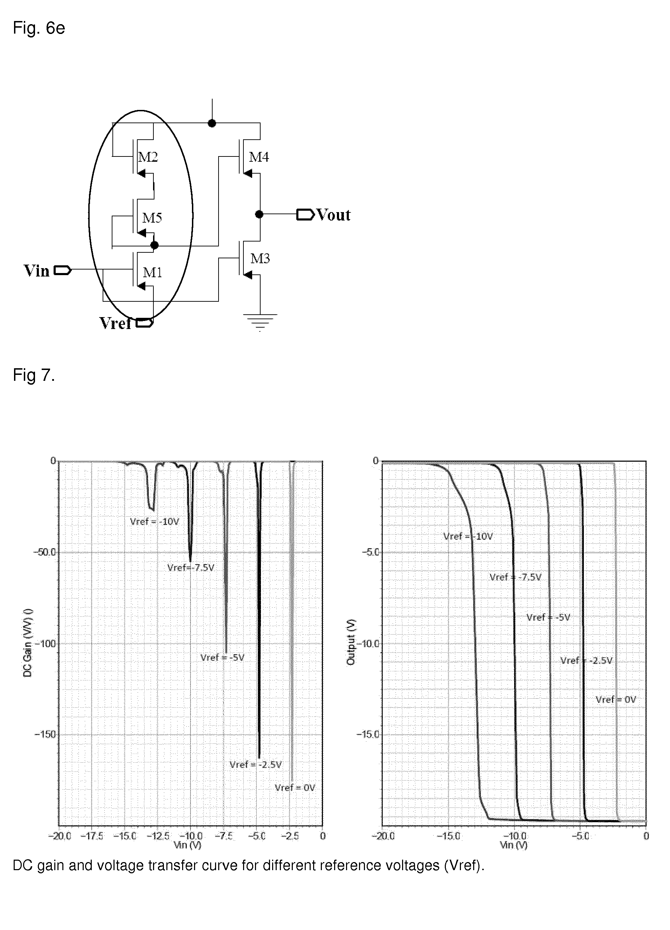

In a further embodiment the comparator comprises than one cascade transistor in form of diode, cut-off load configuration or combination of both (See Fig.6c,d,e).

In a further embodiment the device M2 is a passive device in the the comparator (applicable to circuits in Fig. 6a,b,c,d,e)

In a further embodiment the device M1 and M3 of the comparator are n-type devices (applicable to circuits in Fig. 6a,b,c,d,e)

In addition to the above embodiments, the proposed inverter-based comparator can be used in all electronic circuits that use a comparator in it.

**Claims**

**1.** Comparator comprising:

    an input stage, which is coupled to an input voltage Vin and a reference voltage Vref , build up by a transistor M1, M2 and
    an output stage build up by a transistor M3 and a transistor M4 whereby the input Voltage Vin is connected to the gate of the transistor M1 and the reference voltage Vref is connected to the source of the transistor M1 (and vice versa) and whereby the remaining contact i.e. drain of M1 is connected to the gate of M4
    and this output signal of M1 at gate of M4 triggers M4 to supply +Vsat as Vout and
    whereby the input Voltage Vin is also connected to the gate of M3 and the input Voltage Vin at gate of M3 triggers M3 to supply -Vsat as Vout

**2.** Comparator according to claim 1, comprising a transistor M2 whereby the drain of M1 is connected to the gate and the source or the drain of M2 and the residual drain or source of M2 is connected to +Vsat

**3.** Comparator according to claim 1 or 2 where M2 is formed as a diode-load device

**4.** Comparator according to one of the previous claims with two output levels +Vsat and -Vsat as output Vout

**5.** Comparator according to one of the previous claims, where there is more than one cascade transistor in form of diode, cut-off load configuration or combination of both.

**6.** Comparator according to one of the previous claims, where M2 is a passive device.

**7.** Comparator according to one of the previous claims, where M1 and M3 are n-type devices

**8.** Flash Analog Digital Converter, comprising at least one comparator according to one the claims 1 to 7

**9.** Counter Analog Digital Converter, comprising at least one comparator according to one the claims 1 to 7

**10.** Method for running a comparator according to one the claims 1 to 7 comprising the following steps

    • input Voltage Vin trigger M3 to supply -Vsat as Vout and
    • difference signal of Vref and Vin is generated in M1 and afterwards difference signal of Vref and Vin trigger M4 to supply +Vsat as Vout

# Fig 1.

Level-shifter                    Output stage/ Inverter

*Block diagram of Flash ADC using inverter based comparator*

*Schematic of the proposed inverter based comparator.*

# Fig 2.

Block diagram of a counter ADC.

# Fig 3.

CMOS Inverter-based comparator circuit (Vdd is positive here)

# Fig 4.

Comparator circuit using more than one level-shifter stage (n stages) and one or more inverter stages.

Fig 5.

Fig. 6 – Various possibilities of the level-shifter and the corresponding inverter-based comparator

Fig. 6a

Fig. 6b

Fig.6c

Fig. 6d

Fig. 6e

Fig 7.

DC gain and voltage transfer curve for different reference voltages (Vref).

Fig.8

Voltage transfer curve of an inverter showing the switching voltage Vsw.

Europäisches
Patentamt

European
Patent Office

Office européen
des brevets

# EUROPEAN SEARCH REPORT

Application Number

EP 13 16 0527

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 6 057 712 A (HEIL HOLGER [DE] ET AL) 2 May 2000 (2000-05-02) * the whole document * | 1-10 | INV. H03K5/24 |
| X | US 2010/207666 A1 (NAKAHARA AKIHIRO [JP]) 19 August 2010 (2010-08-19) * figure 8 * | 1-10 | |
| X | US 4 318 013 A (THOMAS JAMES S ET AL) 2 March 1982 (1982-03-02) * the whole document * | 1,4-10 | |
| X | US 2008/084232 A1 (HUANG CHAO HSING [TW] ET AL) 10 April 2008 (2008-04-10) * figures 5,7 * | 1,4-10 | |
| A | LECHANG LIU ET AL: "A 107-pJ/bit 100-kb/s 0.18- $\mu\hbox{m}$ Capacitive-Coupling Transceiver With Data Edge Signaling and DC Power-Free Pulse Detector for Printable Communication Sheet", IEEE TRANSACTIONS ON CIRCUITS AND SYSTEMS I: REGULAR PAPERS, IEEE, US, vol. 56, no. 11, 1 November 2009 (2009-11-01), pages 2511-2518, XP011333551, ISSN: 1549-8328, DOI: 10.1109/TCSI.2009.2015596 * figure 6 * | 1-10 | TECHNICAL FIELDS SEARCHED (IPC) H03K |

The present search report has been drawn up for all claims

| Place of search | Date of completion of the search | Examiner |
|---|---|---|
| Munich | 3 September 2013 | Santos, Paulo |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**ANNEX TO THE EUROPEAN SEARCH REPORT**
**ON EUROPEAN PATENT APPLICATION NO.**

EP 13 16 0527

This annex lists the patent family members relating to the patent documents cited in the above-mentioned European search report.
The members are as contained in the European Patent Office EDP file on
The European Patent Office is in no way liable for these particulars which are merely given for the purpose of information.

03-09-2013

| Patent document cited in search report | | Publication date | Patent family member(s) | | Publication date |
|---|---|---|---|---|---|
| US 6057712 | A | 02-05-2000 | EP | 0651506 A2 | 03-05-1995 |
| | | | JP | H07191065 A | 28-07-1995 |
| | | | US | 6057712 A | 02-05-2000 |
| US 2010207666 | A1 | 19-08-2010 | JP | 2010193036 A | 02-09-2010 |
| | | | US | 2010207666 A1 | 19-08-2010 |
| | | | US | 2013076400 A1 | 28-03-2013 |
| US 4318013 | A | 02-03-1982 | NONE | | |
| US 2008084232 | A1 | 10-04-2008 | TW | 200813444 A | 16-03-2008 |
| | | | US | 2008084232 A1 | 10-04-2008 |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 20080054943 A1, Ravindraraj Ramaraju
- US 7315272 B2, Day-Uei Li
- US 6661365 B1, Alexander Bugeja

**Non-patent literature cited in the description**

- **KOMAR, RAJEEV ; BHAT, M S ; LAXMINIDHI, TONSE.** A 0.5V 300$\mu$W 50MS/s 180nm 6bit Flash ADC using inverter based comparators. *Advances in Engineering, Science and Management (ICAESM,* 2012, 331-335
- **DENIS C. DALY ; ANANTHA P. CHANDRAKASAN.** A 6-bit, 0.2 V to 0.9 V Highly Digital Flash ADC with Comparator Redundancy. *IEEE JOURNAL OF SOLID-STATE CIRCUITS,* 2009, vol. 44 (11